# EUROPEAN PATENT APPLICATION

(11) **EP 3 438 982 A1**
(43) Date of publication of application: **06.02.2019**
(21) Application number: 16896621.6
(22) Date of filing: 07.12.2016
(51) Int. Cl.: G11B 33/00

(54) **HARD DRIVE STORAGE DEVICE**

(30) Priority: 28.03.2016 CN 201620246414 U
(71) Applicant: Shenzhen Orico Technologies Co., Ltd, Shenzhen, Guangdong 518112 (CN)
(72) Inventor: XU, Yeyou, Shenzhen Guangdong 518112 (CN)
(74) Representative: Vitina, Maruta
(86) International application number: PCT/CN2016/108911
(87) International publication number: WO 2017/166853

(57) **Abstract**

A hard drive storage device comprises a hard drive enclosure (10) for accommodating a hard drive (20), and a hub (30) disposed in the hard drive enclosure (10). The hard drive (20) is electrically connected to the hub (30). The hub (30) comprises two or more USB interfaces (31) arranged at a side wall of the hard drive enclosure (10). The hard drive storage device integrates together a storage functionality of the hard drive and a data interface expansion functionality of the hub, and is easy to use and carry.

## Description

### TECHNICAL FIELD

The present invention relates to a hard drive storage device.

### BACKGROUND OF THE PRESENT INVENTION

With the development of the technology of electronic products in the market, host devices (such as laptops or ultrabooks) are getting thinner and lighter, while the installation space of data transmission interfaces of the host devices is correspondingly getting smaller and smaller. The quantity of the data transmission interfaces on the host devices is also limited. Mobile storage devices are often used in our daily work, while the mobile storage devices in the current market usually only have a single storage function. When the storage devices occupy the data transmission interfaces of the host devices, it is difficult for the host devices to provide other enough data transmission interfaces for access of other electronic devices, which brings inconvenience to daily work.

### SUMMARY OF THE PRESENT INVENTION

The main object of the present invention is to provide a hard drive storage device, so as to integrate the function of hard drive storage and a data interface expansion.

To achieve the above object, the present invention proposes a hard drive storage device which includes a hard drive enclosure configured to accommodate a hard drive, and a hub arranged in the hard drive enclosure. The hard drive is electrically connected to the hub. The hub is provided with two or more USB interfaces. The USB interfaces are arranged on a side wall of the hard drive enclosure.

Preferably, the hard drive is a 2.5-inch hard drive or 3.5-inch hard drive.

Preferably, one or more hard drive bodies are arranged.

Preferably, the USB interfaces are USB2.0 or USB3.0.

Preferably, the hard drive enclosure includes a main body. The main body has an enclosure body. The enclosure body is provided with a containing cavity. The hub is arranged in the containing cavity. A plurality of USB interfaces are arranged on two adjacent side walls of the enclosure body.

Preferably, the hub is also provided with an external power interface, and the external power interface is arranged on a side wall of the enclosure body.

Preferably, the main body also includes a fixed frame connected with one side of the enclosure body. The hard drive is arranged in the fixed frame. The hard drive enclosure also includes a lower cover, and the lower cover is buckled with the same side of the fixed frame and the enclosure body to close the hub in the containing cavity.

Preferably, the hard drive enclosure also includes an upper cover, and the upper cover is buckled with the other side of the fixed frame to limit the hard drive to the fixed frame.

Preferably, the upper cover and the main body are connected through a buckle, and the lower cover and the main body are connected through the buckle.

In the technical solution of the present invention, the hard drive and the hub are integrated into the hard drive enclosure, the hard drive and the hub are electrically connected; and two or more USB interfaces are arranged on the side wall of the hard drive enclosure. Thus, the hard drive storage device of the present invention has the hard drive storage function and can also expand the data interfaces, thereby bringing convenience for human work and life.

### BRIEF DESCRIPTION OF THE DRAWINGS

To more clearly describe the technical solutions in the embodiments of the present invention or in the prior art, the drawings required to be used in the description of the embodiments or the prior art will be simply presented below. Apparently, the drawings in the following description are merely some embodiments of the present invention, and for those ordinary skilled in the art, other drawings can also be obtained according to the structures shown in the drawings without contributing creative labor.
FIG. 1 is a structural schematic diagram of an embodiment of a hard drive storage device of the present invention;
FIG. 2 is an exploded structural schematic diagram of a hard drive storage device of FIG. 1 from one visual angle;
FIG. 3 is an exploded structural schematic diagram of a hard drive storage device of FIG. 1 from another visual angle; and
FIG. 4 is an exploded structural schematic diagram of a hard drive storage device of FIG. 1 from the other visual angle.

### Reference numbers:

**Table 1**

| No. | Name | No. | Name |
|---|---|---|---|
| 10 | hard drive enclosure | 16 | lower cover |
| 11 | upper cover | 20 | hard drive |
| 12 | main body | 30 | hub |
| 13 | enclosure body | 31 | USB interface |
| 14 | fixed frame | 32 | external power interface |
| 15 | containing cavity | | |

Realization of the object, functional characteristics and advantages of the present invention will be further described in combination with embodiments with reference to drawings.

### DETAILED DESCRIPTION OF THE PRESENT INVENTION

The technical solutions in the embodiments of the present invention will be clearly and fully described below in combination with the drawings in the embodiments of the present invention. Apparently, the described embodiments are merely part of the embodiments of the present invention, not all of the embodiments. Based on the embodiments in the present invention, all other embodiments obtained by those ordinary skilled in the art without contributing creative labor will belong to the protection scope of the present invention.

It should be indicated that, in the embodiments of the present invention, all directional indications (such as upper, lower, left, right, front and back) are only used to explain the relative position relations, motion conditions etc. of each component under a certain attitude (as shown in the figure). If the certain attitude is changed, the directional indications are changed accordingly.

In the present invention, unless otherwise specifically regulated and defined, terms such as "connection", "fixation" and the like shall be understood in a broad sense. For example, "fixation" may refer to fixed connection or detachable connection or integral connection, may refer to mechanical connection or electrical connection, and may refer to direct connection or indirect connection through an intermediate medium or inner communication of two elements or interaction relationship of two elements, unless otherwise specifically defined. For those ordinarily skilled in the art, the specific meanings of the above terms in the present invention may be understood according to concrete conditions.

In addition, the technical solutions in the embodiments can be combined with each other, but must be based on the realization of those ordinary skilled in the art. When the combinations of the technical solutions are contradictory or unrealizable, it shall be deemed that the combinations of the technical solutions do not exist and are not within the protection scope required by the present invention.

The present invention proposes a hard drive storage device.

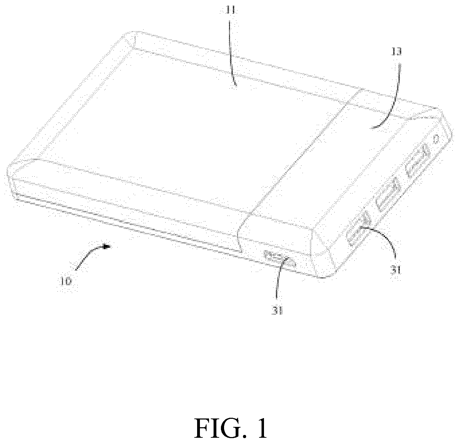

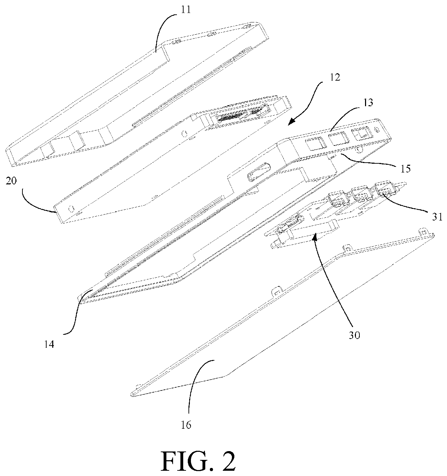

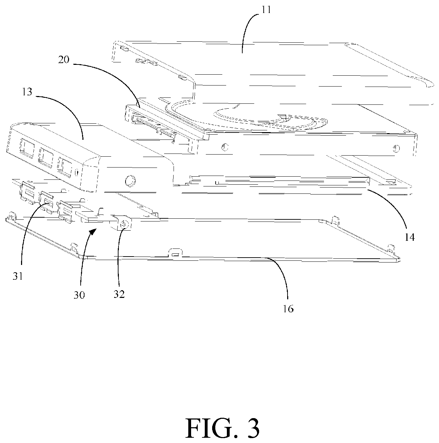

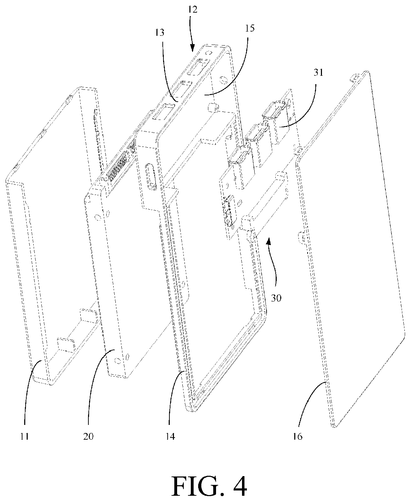

Referring to FIG. 1 to FIG. 4, FIG. 1 is a structural schematic diagram of an embodiment of a hard drive storage device of the present invention. FIG. 2 is an exploded structural schematic diagram of a hard drive storage device of FIG. 1 from a visual angle. FIG. 3 is an exploded structural schematic diagram of a hard drive storage device of FIG. 1 from another visual angle. FIG. 4 is an exploded structural schematic diagram of a hard drive storage device of FIG. 1 from still another visual angle.

In an embodiment of a hard drive storage device of the present invention, the hard drive storage device includes a hard drive enclosure 10 configured to accommodate a hard drive 20, and a hub 30 arranged in the hard drive enclosure 10. The hard drive 20 is electrically connected to the hub 30. The hub 30 is provided with two or more USB interfaces 31. The USB interfaces 31 are arranged on a side wall of the hard drive enclosure 10.

Understandably, the hub 30 includes a main control PCB (not shown). A plurality of USB interfaces 31 are connected to the main control PCB. The hub 30 and the hard drive 20 can be electrically connected through a SATA data line. In the present embodiment, four USB interfaces 31 are arranged. One USB interface 31 can be used for connecting a computer. Other USB interfaces 31 are used by users. The USB interfaces 31 may be USB2.0 or USB3.0. After the hard drive storage device of the present invention is connected to the computer, the hub 30 as an intermediate realizes communication between the hard drive 20 and the computer and the computer reads and writes the hard drive 20 through the hub 30. The hard drive enclosure 10 may be plastic and can be produced through injection molding.

In the technical solution of the present invention, the hard drive 20 and the hub 30 are integrated and arranged in the hard drive enclosure 10; the hard drive 20 and the hub 30 are electrically connected; and a plurality of USB interfaces 31 are arranged on the side wall of the hard drive enclosure 10. Thus, the hard drive storage device of the present invention has the hard drive storage function and also has the data interface expansion function of the hub 30, thereby bringing convenience for human work and life.

The hard drive 20 may be a 2.5-inch hard drive or 3.5-inch hard drive. The 2.5-inch hard drive or 3.5-inch hard drive is used more frequently in daily life. The size of the hard drive enclosure 10 in the present embodiment is matched with the size of the hard drive 20. The internal space of the hard drive enclosure 10 is enough to accommodate the hard drive 20.

One or more hard drive bodies 20 are arranged. The hard drive bodies 20 can be stacked in the hard drive enclosure 10. When the hard drive storage device in the present embodiment is provided with a plurality of hard drive bodies 20, the hard drive storage device also has a drive array function.

Referring to FIG. 2 and FIG. 4, specifically, the hard drive enclosure 10 includes a main body 12. The main body 12 has an enclosure body 13. The enclosure body 13 is provided with a containing cavity 15. The hub 30 is arranged in the containing cavity 15. A plurality of USB interfaces 31 are arranged on two adjacent side walls of the enclosure body 13.

Four USB interfaces 31 in the present embodiment are arranged on two adjacent side walls of the enclosure body 13. One side wall is provided with one USB interface; and the other side wall is provided with three USB interfaces. In the process of using the hard drive storage device, the USB interface 31 is connected through a USB cable. The USB interface 31on one side wall of the enclosure body 13 faces the computer and while the USB interfaces 31 on the other side wall of the enclosure body 13 faces the user so that the user can easily connect other electronic devices to the hard drive storage device. It is convenient to use the device.

Referring to FIG. 3, the hub 30 is also provided with an external power interface 32; and the external power interface 32 is arranged on a side wall of the enclosure body 13. The hard drive storage device in the present embodiment can be powered through the USB interfaces 31. When the output power of the data interfaces of the computer is not enough, external commercial power can also be connected through the external power interface 32 for supplying the power, so as to ensure that the hard drive storage device is normally used in many cases.

Further, referring to FIG. 2 to FIG. 4, the main body 12 also includes a fixed frame 14 connected with one side of the enclosure body 13; the hard drive 20 is arranged in the fixed frame 14; the hard drive enclosure 10 also includes an upper cover 11 and a lower cover 16; the lower cover 16 is buckled with the fixed frame 14 and the enclosure body 13 to close the hub 30 in the containing cavity 15; and the upper cover 11 is buckled with the other side of the fixed frame 14 to limit the hard drive 20 to the fixed frame 14.

The upper cover 11 and the main body 12 of the hard drive storage device in the present embodiment are connected through a buckle structure; and the lower cover 16 and the main body 12 are also connected through the buckle structure. The upper cover 11 and the lower cover 16 are easy to disassemble from the main body 12. In the process of using, the user can easily replace the hard drive 20, thereby performing data read-write operation for different hard drives. And the process of using is convenient.

The above only describes preferred embodiments of the present invention and is not intended to limit the patent scope of the present invention. Any equivalent structural transformation made by using contents of the description and drawings of the present invention, or directly or indirectly used in other relevant technical fields under the inventive concept of the present invention shall be included within the protection scope of patent of the present invention.

## Claims

1. A hard drive storage device, **characterized in that** the device comprises a hard drive enclosure for accommodating a hard drive, and a hub disposed in the hard drive enclosure, wherein the hard drive is electrically connected to the hub; the hub is provided with two or more USB interfaces; and the USB interfaces are arranged on a side wall of the hard drive enclosure.

2. The hard drive storage device according to claim 1, **characterized in that** the hard drive is a 2.5-inch hard drive or 3.5-inch hard drive.

3. The hard drive storage device according to claim 2, **characterized in that** one or more hard drives are arranged.

4. The hard drive storage device according to claim 1, **characterized in that** the USB interfaces are USB2.0 or USB3.0.

5. The hard drive storage device according to claim 1, **characterized in that** the hard drive enclosure comprises a main body; the main body has a enclosure body; the enclosure body is provided with a containing cavity; the hub is arranged in the containing cavity; and a plurality of USB interfaces are arranged on two adjacent side walls of the enclosure body.

6. The hard drive storage device according to claim 5, **characterized in that** the hub is also provided with an external power interface; and the external power interface is arranged on a side wall of the enclosure body.

7. The hard drive storage device according to claim 5, **characterized in that** the main body also comprises a fixed frame connected with one side of the enclosure body; the hard drive is arranged in the fixed frame; the hard drive enclosure also comprises a lower cover; and the lower cover is buckled with the same side of the fixed frame and the enclosure body to close the hub in the containing cavity.

8. The hard drive storage device according to claim 7, **characterized in that** the hard drive enclosure also comprises an upper cover; and the upper cover is buckled with the other side of the fixed frame to limit the hard drive to the fixed frame.

9. The hard drive storage device according to claim 8, **characterized in that** the upper cover and the main body are connected through a buckle; and the lower cover and the main body are connected through the buckle.
